# EUROPÄISCHE PATENTSCHRIFT

(11) **EP 1 052 682 B1**
(45) Veröffentlichungstag und Bekanntmachung des Hinweises auf die Patenterteilung: **09.01.2002**
(21) Anmeldenummer: 99108319.7
(22) Anmeldetag: 28.04.1999
(51) Int. Cl.: H01L 21/00

(54) **Vorrichtung und Verfahren zur Flüssigkeitsbehandlung von scheibenförmigen Gegenständen**
Device and process for the liquid treatment of disk-shaped objects
Dispositif et procédé pour le traitement par liquide d'objets en forme de disque

(43) Veröffentlichungstag der Anmeldung: 15.11.2000
(73) Patentinhaber: SEZ Semiconductor-Equipment Zubehör für die Halbleiterfertigung AG, 9500 Villach (AT)
(72) Erfinder: Langen, Kurt, 9500 Villach (AT)

(56) Entgegenhaltungen:
- EP-A- 0 810 641
- US-A- 5 608 943
- PATENT ABSTRACTS OF JAPAN vol. 097, no. 011, 28. November 1997 (1997-11-28) -& JP 09 181026 A (TOSHIBA CORP), 11. Juli 1997 (1997-07-11)

## Beschreibung

Die Erfindung betrifft eine Vorrichtung und ein Verfahren zur Flüssigkeitsbehandlung eines definierten, randnahen Abschnitts eines scheibenförmigen Gegenstandes, insbesondere eines Wafers.

Der Grund für eine Behandlung eines definierten, randnahen Abschnitts eines scheibenförmigen Gegenstandes, insbesondere eines Wafers, soll im folgenden beschrieben werden.

Ein Wafer, beispielsweise ein Siliziumwafer, kann beispielsweise allseitig eine Beschichtung von Siliziumdioxid aufweisen. Für nachfolgende Prozesse (wenn zum Beispiel eine Goldschicht oder eine Schicht aus Polysilizium (polykristallinem Silizium) aufgebracht werden soll) kann es notwendig sein, den Wafer zumindest im Randbereich einer Hauptoberfläche, gegebenenfalls aber auch im Bereich seiner Umfangsfläche und/oder der zweiten Hauptoberfläche von der vorhandenen Beschichtung zu befreien. Dies geschieht durch Ätzverfahren, die sich vor allem in Trockenätzverfahren und Naßätzverfahren untergliedern lassen.

Eine weitere Anwendung ist die Reinigung von Wafern. Hier kann es notwendig sein, eine den Wafer zumindest im Randbereich einer Hauptoberfläche, gegebenenfalls aber auch im Bereich seiner Umfangsfläche und/oder der zweiten Hauptoberfläche zu reinigen, d.h. von Partikeln und/oder anderen Kontaminationen zu befreien. Dies geschieht durch Naßreinigungsverfahren.

Die Erfindung ist auf das Naßätzen bzw. Naßreinigen (zusammengefaßt unter dem Begriff Flüssigkeitsbehandlung) gerichtet. Dabei wird der zu behandelnde Flächenabschnitt des Wafers mit der Behandlungsflüssigkeit benetzt und die zu entfernende Schicht bzw. die Verunreinigungen abgetragen.

Eine Vorrichtung zur Durchführung einer derartigen Flüssigkeitsbehandlung wird z.B. in der EP 0 444 714 B1 beschrieben. Bei dieser Vorrichtung ist der scheibenförmige Gegenstand (Wafer) auf einem rotierenden Träger (Spin Chuck) montiert. Auf die zu behandelnde Oberfläche des Wafer wird eine Behandlungsflüssigkeit, beispielsweise eine Ätzflüssigkeit, aufgetragen, die Flüssigkeit verteilt sich aufgrund der Rotationsbewegung des Wafers über dessen Oberfläche und wird seitlich über die Kante des Wafers weggeschleudert.

Um zu verhindern, daß die Behandlungsflüssigkeit unkontrolliert auf die nicht zu behandelnde Oberfläche gelangt, wird in der EP 0 316 296 B1 ein Träger (Chuck) vorgeschlagen, der die nicht zu behandelnde, dem Träger zugewandte Oberfläche mit einem Gas spült. Dabei tritt das Gas zwischen der Waferkante und dem Träger aus.

Die JP 09-181026 A beschreibt einen Träger für Halbleiterscheiben, der außerhalb einer Ringdüse eine besondere Form, z.B. eine ringförmige, nach außen hin abfallende Stufe oder eine Abschrägung seines Randes, aufweist. Auch wird eine Einsaugöffnung vorgeschlagen. Durch diese Formgebung bzw. die Einsaugöffnung soll die Strömungsgeschwindigkeit im Randbereich beeinflußt (verringert) werden. Dies soll dazu dienen, daß die von oben aufgebrachte Behandlungsflüssigkeit über den Rand des Wafers hinaus auf die dem Chuck zugewandte Seite fließt und dort einen Randbereich behandelt

Unabhängig davon, ob nun eine Einrichtung zur Aufnahme des scheibenförmigen Gegenstandes (Träger bzw. Chuck) nach EP 0 316 296 B1 oder JP 09-181026 A verwendet wird, kann auf der dem Träger zugewandten Hauptoberfläche maximal ein Randbereich von 1,5 mm (gemessen vom äußeren Rand des Wafers) behandelt werden. Die Flüssigkeit fließt danach wieder in Richtung Waferkante und wird von dieser abgeschleudert.

Dementsprechend liegt nun der Erfindung die Aufgabe zugrunde, eine Möglichkeit aufzuzeigen, auf einer Oberfläche eines scheibenfönnigen Gegenstandes einen definierten, randseitigen Abschnitt mit einer Flüssigkeit zu behandeln, wobei es auch möglich sein soll einen Randbereich von über 2 mm (gemessen vom äußeren Rand des Wafers) zu behandeln.

Danach schlägt die Erfindung in ihrer allgemeinsten Ausführungsform eine Vorrichtung zur Flüssigkeitsbehandlung eines definierten, randnahen Abschnitts eines scheibenförmigen Gegenstandes, insbesondere eines Wafers, vor, mit einer Einrichtung zum Tragen des scheibenförmigen Gegenstandes, mit einer Gaszuführvorrichtung zur zumindest teilweisen Gasspülung der der Einrichtung zugewandten Oberfläche des scheibenförmigen Gegenstandes, bei der umfangsseitig eine Gasleitvorrichtung vorgesehen ist, die den Großteil des Spülgases, im Randbereich des scheibenförmigen Gegenstandes vom scheibenförmigen Gegenstand weg leitet. Die Gasleitvorrichtung besitzt die Form eines Ringes. Der Teil der Einrichtung, der zwischen der Gaszuführvorrichtung und der Gasleitvorrichtung ist (Grundkörper), befindet sich im größeren Abstand zum scheibenförmigen Gegenstand (Wafer) als die Gasleitvorrichtung zum scheibenförmigen Gegenstand. Dadurch kann mehr Gas zwischen Wafer und diesem Teil (Grundkörper) fließen als zwischen Wafer und Gasleitvorrichtung. Das meiste Gas muß daher auf der dem Wafer abgewandten Seite der Gasleitvorrichtung an dieser vorbei strömen. Die Gasleitvorrichtung ist so ausgestaltet, daß diese, wenn sich ein scheibenförmiger Gegenstand (Wafer) auf dem Träger befindet, den scheibenförmigen Gegenstand (Wafer) nicht berührt, d.h. zwischen dem Wafer und dem Ring ein Spalt bleibt.

Die Einrichtung zum Tragen (Träger) dient dazu den Wafer zu halten. Dabei kann das Halten mit Hilfe von Vakuum erfolgen, oder der Wafer schwebt auf einem Luftpolster und wird durch seitliche Führungselemente am seitlichen Ausgleiten gehindert.

Auch kann der Wafer dadurch gehalten werden, daß das an der Waferunterseite vorbeiströmende Gas dadurch einen Unterdruck ausbildet (auch als Bernoulli-Effekt bezeichnet), wodurch der Wafer eine Kraft in Richtung Träger erfährt. Durch einen erhöhten Teil des Trägers innerhalb der Gaszuführvorrichtung wird der Wafer berührt, wodurch dieser am seitlichen Ausgleiten gehindert wird.

Über die Gaszuführvorrichtung kann Gas auf die Unterseite (die dem Träger zugewandte Oberfläche) des scheibenförmigen Gegenstandes (Wafers) geführt werden, um zu verhindern, daß Flüssigkeit auf diese Unterseite gelangt und so eine unerwünschte Behandlung durchführt. Das dafür verwendete Gas sollte gegenüber der Oberfläche, auf die es strömt, inert sein; geeignet sind z.B. Stickstoff oder Reinstluft.

Die Gaszuführvorrichtung kann aus einer oder mehreren Düsen oder einer Ringdüse bestehen. Die Düsen sollten symmetrisch zum Mittelpunkt des Trägers angebracht sein, um über den gesamten Umfang eine gleichmäßige Gasströmung zu ermöglichen.

Die Gasleitvorrichtung dient dazu, daß das Gas, das vom mittleren Teil des Trägers kommend in Richtung Rand des Wafers hin strömt, vom Randbereich weggeleitet wird. Das Gas strömt nun auf der Seite der Gasleitvorrichtung vorbei, die dem scheibenförmigen Gegenstand abgewandt ist. Je weiter innen (zum Mittelpunkt des Trägers hin) diese Gasleitvorrichtung angebracht ist, desto größer ist nun der Randbereich.

Da nun im randnahen Abschnitt der Unterseite des Wafers im wesentlichen kein Gas mehr nach außen strömt, kann bei der Behandlung mit Flüssigkeit diese um die Waferkante herum auf die Unterseite fließen und so den randnahen Abschnitt der Waferunterseite benetzen.

Der Vorteil der Erfindung gegenüber dem Stand der Technik ist, daß durch geeignete Wahl der Gasleitvorrichtung die Größe des randnahen Abschnittes beliebig gewählt werden kann.

Durch geeignete Ausformung der Gasleitvorrichtung kann der am Spalt zwischen Gasleitvorrichtung und Wafer vorbei fließende Gasstrom sogar innerhalb dieses Spaltes Unterdruck erzeugen, wodurch zusätzlich im Randbereich Gas aus der Umgebung von der Waferkante nach innen strömt. Während der Flüssigkeitsbehandlung wird so Flüssigkeit in den Randbereich gesaugt.

Der Ring kann mit Hilfe von z.B. drei oder mehreren Distanzstücken auf dem Grundkörper des Trägers befestigt sein. Er kann aber auch durch entsprechendes Fräsen aus dem Grundkörper heraus gearbeitet sein.

Der Ring besitzt in einer Ausführungsform einen Innendurchmesser, der kleiner ist als der Außendurchmesser des scheibenförmigen Gegenstandes, und einen Außendurchmesser, der mindestens gleich groß ist wie der Außendurchmesser des scheibenförmigen Gegenstandes.

Dadurch kann Flüssigkeit, die um den umfangseitigen Rand des scheibenförmigen Gegenstandes (um die Waferkante) fließt, durch den Ring aufgefangen werden und nach innen gefördert werden.

Die Gasleitvorrichtung kann auch durch eine ringförmige, zum Umfang der Einrichtung konzentrische Nut, gebildet werden, aus der das Gas nach außen abgeführt wird. Dies kann durch einfache Bohrungen die vom Boden der Nut im Grundkörper des Trägers nach außen führen gewährleistet werden.

Bei einer weiteren Ausführungsform weist die Gasleitvorrichtung an ihrem inneren Umfang eine scharfe Kante auf (Kantenwinkel kleiner 60°). Dadurch kann nahezu das gesamte Gas im Randbereich vom Wafer weggeleitet werden.

Der Spalt zwischen der Gasleitvorrichtung und dem scheibenförmigen Gegenstand beträgt in einer Ausführungsform 0,05 bis 1 mm, vorteilhafterweise 0,1 bis 0,5 mm. Dadurch bildet sich zwischen dem Wafer und der Gasleitvorrichtung eine Art Kapillare aus, von der Flüssigkeit, die um die Waferkante geflossen ist, angesaugt wird. Der Innendurchmesser der von der Flüssigkeit benetzten, der Gasleitvorrichtung zugewandten Oberfläche ist kleiner als der Innendurchmesser der Ringfläche der Gasleitvorrichtung.

Es ist von Vorteil, wenn die dem scheibenförmigen Gegenstand zugewandte Fläche der Gasleitvorrichtung zu den Hauptoberflächen des scheibenförmigen Gegenstands parallel ist. Der Spalt zwischen dem scheibenförmigen Gegenstand (Wafer) und der Gasleitvorrichtung ist dadurch im gesamten Randbereich gleich groß.

Eine Ausführungsform sieht vor, daß der Träger in Rotation versetzt werden kann. Dies ist, wenn auch nicht notwendig, so doch vorteilhaft, da die Behandlungsflüssigkeit sowohl vom Träger als auch von der Waferkante abgeschleudert werden kann. Ist der Träger während der Flüssigkeitsbehandlung nicht in Rotation, so wird die Flüssigkeit durch den Gasstrom mitgenommen bzw. abgeblasen.

Ein weiterer Teil der Erfindung ist ein Verfahren zur Flüssigkeitsbehandlung eines definierten, randnahen Bereichs eines scheibenförmigen Gegenstandes, insbesondere eines Wafers, mit der erfindungsgemäßen Vorrichtung. Bei diesem Verfahren wird die Flüssigkeit auf eine erste, der Flüssigkeitsquelle zugewandten Oberfläche aufgebracht. Die Flüssigkeit fließt im wesentlichen radial nach außen zum umfangseitigen Rand des scheibenförmigen Gegenstands (Waferkante), um diesen Rand herum auf die zweite, der Flüssigkeitsquelle abgewandten Oberfläche. Die Flüssigkeit strömt in den Spalt zwischen Wafer und Ring und benetzt auf der zweiten Oberfläche einen definierten, randnahen Abschnitt und wird daraufhin vom scheibenförmigen Gegenstand entfernt.

Der Vorteil gegenüber dem Stand der Technik ist, d;aß bei diesem Verfahren auch der Teil des Flüssigkeitsstromes,der auf den randnahen Abschnitt der zweiten Oberfläche kommt, auf diesem in eine vorgegebene Richtung fließt (vom Rand (Waferkante) kommend in Richtung Wafermitte) und nicht wieder zum Rand zurückfließen muß. Vielmehr wird die Flüssigkeit vom innenseitigen Rand des randnahen Abschnittes entfernt.

In einer Ausführungsform des Verfahrens wird der Randbereich größer als 2 mm gewählt.

Bei einer weiteren Ausführungsform des Verfahrens rotiert der scheibenförmige Gegenstand während der Flüssigkeitsbehandlung um seine Achse, wodurch die Behandlungsflüssigkeit von Rand des scheibenförmigen Gegenstandes, bzw. der Waferkante, abgeschleudert wird.

Vorteilhafterweise beträgt die Rotationsgeschwindigkeit mindestens 100/min, um die Flüssigkeit gut ab zu schleudern.

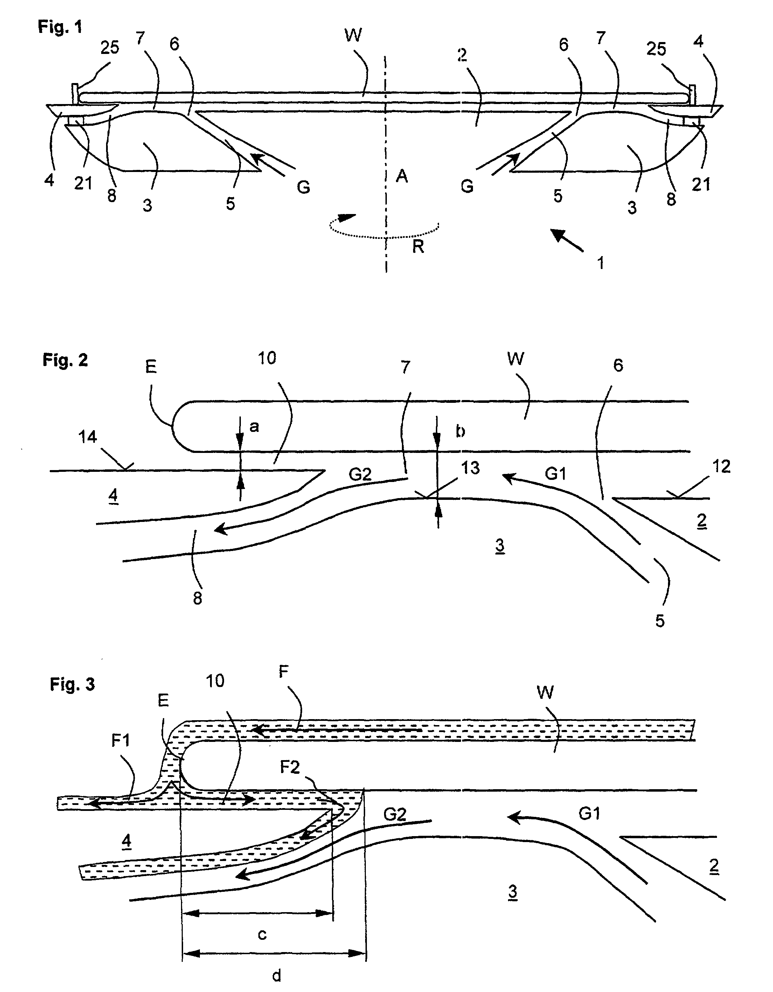

Weitere Einzelheiten, Merkmale und Vorteile der Erfindung ergeben sich aus der nachstehenden Beschreibung der in den Zeichnungen gezeigten Ausführungsbeispiele der Erfindung. Es zeigt Fig. 1 schematisch einen Achsialschnitt der Einrichtung (Träger) 1 inklusive einem darauf befindlichen Wafer.

Die Fig. 2 und 3 stellen schematisch einen Achsialschnitt des Randbereiches des Trägers dar. Darin ist auch die Gasführung erkennbar. In Fig. 3 ist darüber hinaus auch die Bewegung der Flüssigkeit während einer Behandlung dargestellt.

Der Träger 1 besteht im wesentlichen aus drei Teilen (2, 3, 4), dem Grundkörper 3, dem Deckel 2 und der Gasleitvorrichtung 4. Der Grundkörper 3 ist ringförmig ausgestaltet und ist mit einem hohlen Schaft (nicht dargestellt) verbunden, der einerseits den Träger in Drehung (dargestellt durch den Pfeil R) versetzen kann und andererseits die Gaszuführvorrichtung (5, 6) mit Gas G versorgen kann.

In den Grundkörper ist der Deckel 2 so eingesetzt, und mit diesem verbunden (nicht dargestellt), daß zwischen Deckel 2 und Grundkörper 3 ein ringförmiger Gaskanal 5 ausgebildet wird, der auf der Oberseite (der dem Wafer zugewandten Seite) in einen ringförmigen Spalt, der Ringdüse 6, mündet. Der Durchmesser der Ringdüse 6 ist kleiner als der Innendurchmesser der Gasleitvorrichtung 4.

Der dargestellte Träger funktioniert nach dem "Bernoulli-Prinzip". Außerhalb der Ringdüse 6 (im Bereich 7) wird dabei ein Gaspolster ausgebildet auf dem der Wafer schwebt. Am seitlichen Ausgleiten wird der Wafer durch umfangsseitig angebrachte Führungselemente (Stifte 25) gehindert und durch diese bei der Rotation des Trägers um die Achse A mitgenommen. Die Stifte sind beweglich (nicht dargestellt)

Die Gasleitvorrichtung 4 hat die Form eines Ringes und ist auf dem Grundkörper 3 auf der Oberseite (der dem Wafer zugewandten Seite) mit Hilfe von einer Vielzahl, am Umfang regelmäßig verteilten Distanzstücken 21 befestigt. Der Ring 4 besitzt einen Innendurchmesser, der kleiner ist als der Außendurchmesser des Wafers W, und einen Außendurchmesser, der größer ist als der Außendurchmesser des Wafers W.

Die dem Wafer W zugewandte Fläche 14 der Gasleitvorrichtung ist eine ebene Kreisringfläche, die parallel zu den Hauptoberflächen des Wafers ist. Zwischen der Fläche 14 und der dem Träger zugewandten Oberfläche des Wafers wird, wenn sich der Wafer auf dem Träger befinden, ein Ringspalt 10 ausgebildet. Die Tiefe des Spalts c (Fig. 3) entspricht dabei der Differenz des Außenradius des Wafers W und des Innenradius der Gasleitvorrichtung 4, Die Breite a (Fig. 2) ergibt sich durch den Abstand von der Fläche 14 zur dem Träger zugewandten Oberfläche des Wafers.

Zwischen der Gasleitvorrichtung 4 und dem Grundkörper 3 ist ein ringförmiger Gasabführkanal 8 ausgebildet, in den das Gas durch die Gasleitvorrichtung 4 abgeleitet wird. Der Gesamtquerschnitt des Spaltes 10 ist wesentlich kleiner als der des Gasabführkanales 8, wodurch durch letzteren der Großteil des Gases abgeführt werden kann.

Im Bereich 7 zwischen Wafer W und Grundkörper 3 bzw. zwischen Ringdüse 6 und Gasleitvorrichtung 4 strömt das Gas direkt an der dem Träger zugewandten Oberfläche des Wafers entlang. Der engste Querschnitt in diesem Bereich befindet sich zwischen der Fläche 13 (der dem Wafer zugewandten Fläche des Grundkörpers 3) und dem Wafer und ist in Fig. 2 mit b dargestellt. Der Abstand b des Grundkörpers 3 zum Wafer ist größer als der Abstand a der Gasleitvorrichtung zum Wafer. Die dem Wafer zugewandte Fläche 12 des Deckels 3 befindet sich im wesentlichen in der gleichen Ebene wie die Fläche 13 des Grundkörpers.

Befindet sich der Wafer auf dem Träger, so wird er durch den Gaspolster im Bereich 7 in Schwebe gehalten, wobei er weder den Deckel 2 noch die Gasleitvorrichtung 4 berührt. Das Gas entweicht aus der Ringdüse 6 (Gasstrom G1) und wird über den Gasabführkanal 8 abgeführt (Gasstrom G2). Eine geringe Gasmenge kann über den Spalt 10 entweichen, jedoch wird wahrscheinlich durch den Gasstrom G2 ein Unterdruck erzeugt, wodurch sogar Gas aus der Umgebung über den Spalt 10 eingesaugt und durch den Gasstrom G2 mitgerissen wird.

Während der Flüssigkeitsbehandlung wird die Flüssigkeit auf die dem Träger 1 abgewandte Oberfläche aufgebracht, diese fließt dann in Richtung Waferkante (Flüssigkeitsstrom F) und um die Waferkante E herum. Bei Rotation des Wafers kann ein Teil der Flüssigkeit direkt von der Waferkante abgeschleudert werden (nicht dargestellt). Dann teilt sich der Flüssigkeitsstrom in zwei Ströme F1 und F2 auf. Der Flüssigkeitsstrom F1 strömt vom Wafer weg.

Der Flüssigkeitsstrom F2 strömt in den Spalt 10 und benetzt so die Unterseite des Wafers. F2 benetzt den Randbereich dieser Oberfläche etwas weiter als die Gasleitvorrichtung nach innen reicht. Daher ist der benetzte Bereich d etwas größer als die Tiefe des Spaltes c. Hier wird der Flüssigkeitsstrom F2 durch den Gasstrom G2 um die innere Kante der Gasleitvorrichtung umgelenkt, und der Flüssigkeitsstrom F2 und der Gasstrom G2 verlassen den Träger gemeinsam über den Gasabführkanal.

## Patentansprüche

1. Vorrichtung zur Flüssigkeitsbehandlung eines definierten, randnahen Abschnitts eines scheibenförmigen Gegenstandes, insbesondere eines Wafers (W), mit einer Einrichtung (1) zum Tragen des scheibenförmigen Gegenstandes, mit einer Gaszuführvorrichtung (5) zur zumindest teilweisen, vor einer Flüssigkeitsbehandlung schützenden Gasspülung der der Einrichtung zugewandten Oberfläche des scheibenförmigen Gegenstandes, **dadurch gekennzeichnet, daß** umfangsseitig eine Gasleitvorrichtung (4), die die Form eines Ringes besitzt, vorgesehen ist, die den Großteil des Spülgases, im Randbereich der genannten Oberfläche des scheibenförmigen Gegenstandes, vom scheibenförmigen Gegenstand weg leitet, um eine Flüssigkeitsbehandlung dieses Randbereiches zu ermöglichen, daß der Teil (3) der Einrichtung, der zwischen der Gaszuführvorrichtung und der Gasleitvorrichtung ist, sich im größeren Abstand (b) zum scheibenförmigen Gegenstand befindet als die Gasleitvorrichtung (4) zum scheibenförmigen Gegenstand (W) (Abstand a), und daß die Gasleitvorrichtung den scheibenförmigen Gegenstand im Betrieb nicht berührt.

2. Vorrichtung nach Anspruch 1, bei der die Gasleitvorrichtung (4) einen Innendurchmesser besitzt, der kleiner ist als der Außendurchmesser des scheibenförmigen Gegenstandes (W), und einen Außendurchmesser, der mindestens gleich groß ist wie der Außendurchmesser des scheibenförmigen Gegenstandes.

3. Vorrichtung nach Anspruch 1, bei der die Gasleitvorrichtung (4) an ihrem inneren Umfang eine scharfe Kante aufweist.

4. Vorrichtung nach Anspruch 1, bei der der Spalt (10) zwischen der Gasleitvorrichtung (4) und dem scheibenförmigen Gegenstand (W) 0,05 bis 1 mm beträgt (Abstand a).

5. Vorrichtung nach Anspruch 4, bei der der Spalt (10) zwischen der Gasleitvorrichtung (4) und dem scheibenförmigen Gegenstand (W) 0,1 bis 0,5 mm beträgt (Abstand a).

6. Vorrichtung nach Anspruch 1, bei der die dem scheibenförmigen Gegenstand (W) zugewandte Fläche (14) der Gasleitvorrichtung (4) zu den Hauptoberflächen des scheibenförmigen Gegenstandes parallel ist.

7. Vorrichtung nach Anspruch 1, mit mindestens zwei, senkrecht zur Einrichtung angeordneten, die Position des scheibenförmigen Gegenstandes umfangsseitig begrenzenden Führungselementen (25).

8. Vorrichtung nach Anspruch 7, bei der die Gaszuführvorrichtung (5) einen Gaspolster aufbaut, der den scheibenförmigen Gegenstand zum Schweben bringt.

9. Vorrichtung nach Anspruch 1, bei der der Teil (2) der Einrichtung innerhalb der Gaszuführvorrichtung den scheibenförmigen Gegenstand berührt.

10. Vorrichtung nach Anspruch 9, bei der der Teil (2) der Einrichtung innerhalb der Gaszuführvorrichtung mit Vakuum beaufschlagbar ist.

11. Vorrichtung nach Anspruch 1, bei der die Einrichtung in Rotation (R) versetzt werden kann.

12. Verfahren zur Flüssigkeitsbehandlung eines definierten, randnahen Bereichs (d) eines scheibenförmigen Gegenstandes, insbesondere eines Wafers (W), mit einer Vorrichtung nach Anspruch 1, bei dem die Flüssigkeit (F) auf eine erste Oberfläche aufgebracht wird, im wesentlichen radial nach außen zum umfangseitigen Rand (E) des scheibenförmigen Gegenstandes (W) fließt und um diesen Rand (E) herum auf die zweite Oberfläche fließt, **dadurch gekennzeichnet, daß** die Flüssigkeit auf der zweiten Oberfläche einen definierten, randnahen Abschnitt benetzt und daraufhin vom scheibenförmigen Gegenstand entfernt wird.

13. Verfahren nach Anspruch 12, bei dem der Randbereich (d) größer 2 mm beträgt.

14. Verfahren nach Anspruch 12, bei dem der scheibenförmige Gegenstand während der Flüssigkeitsbehandlung um seine Achse (A) rotiert.

15. Verfahren nach Anspruch 14 bei dem die Rotationsgeschwindigkeit mindestens 100/min beträgt.

## Claims

1. Device for the liquid treatment of a defined, near-edge portion of a disc-shaped object, in particular of a wafer (W), having an arrangement (1) for carrying the disc-shaped object, having a gas supply device (5) for at least partial gas flushing, which protects against a liquid treatment, of the surface of the disc-shaped object, which surface is orientated towards the arrangement, **characterised in that** a gas conducting device (4) is provided circumferentially, which has the form of a ring and conducts the greater part of the flushing gas away from the disc-shaped object in the edge region of the mentioned surface of the disc-shaped object, in order to make possible a liquid treatment of this edge region, **in that** the part (3) of the arrangement, which is between the gas supply device and the gas conducting device, is situated at a greater spacing (b) from the disc-shaped object than the gas conducting device (4) from the disc-shaped object (W) (spacing a), and **in that**, during operation, the gas conducting device does not come into contact with the disc-shaped object.

2. Device according to claim 1, in which the gas conducting device (4) has an internal diameter which is smaller that the external diameter of the disc-shaped object (W) and an external diameter which is at least as large as the external diameter of the disc-shaped object.

3. Device according to claim 1, in which the gas conducting device (4) has a sharp edge at its internal circumference.

4. Device according to claim 1, in which the gap (10) between the gas conducting device (4) and the disc-shaped object (W) is 0.05 to 1 mm (spacing a).

5. Device according to claim 4, in which the gap (10) between the gas conducting device (4) and the disc-shaped object (W) is 0.1 to 0.5 mm (spacing a).

6. Device according to claim 1, in which the face (14) of the gas conducting device (4) which is orientated towards the disc-shaped object (W) is parallel to the main surfaces of the disc-shaped object.

7. Device according to claim 1, having at least two guide elements (25) which are disposed perpendicularly to the arrangement and circumferentially delimit the position of the disc-shaped object .

8. Device according to claim 7, in which the gas supply device (5) constructs a gas cushion which causes the disc-shaped object to hover.

9. Device according to claim 1, in which the part (2) of the arrangement within the gas supply device comes into contact with the disc-shaped object.

10. Device according to claim 9, in which the part (2) of the arrangement within the gas supply device can have a vacuum applied to it.

11. Device according to claim 1, in which the arrangement can be displaced in rotation (R).

12. Method for the liquid treatment of a defined, near-edge region (d) of a disc-shaped object, in particular of a wafer (W), having a device according to claim 1, in which the liquid (F) is applied to a first surface, flows substantially radially outwards to the circumferential edge (E) of the disc-shaped object (W) and flows around this edge (E) to the second surface, **characterised in that** the liquid wets a defined near-edge portion on the second surface and thereupon is removed from the disc-shaped object.

13. Method according to claim 12, in which the edge region (d) is greater than 2 mm.

14. Method according to claim 12, in which the disc-shaped object rotates about its axis (A) during the liquid treatment.

15. Method according to claim 14, in which the rotational speed is at least 100/min.

## Revendications

1. Dispositif pour le traitement par liquide d'une portion définie, proche du bord, d'un objet en forme de disque, en particulier d'une plaquette de semi-conducteur (W), comprenant un système (1) pour supporter l'objet en forme de disque, un dispositif d'amenée de gaz (5) pour rincer au moins partiellement, en vue de sa protection contre un traitement par liquide, la surface de l'objet en forme de disque tournée vers le système, **caractérisé par le fait qu'**il est prévu côté périphérie un dispositif de guidage de gaz (4) qui présente la forme d'un anneau et éloigne de l'objet en forme de disque la majeure partie du gaz de rinçage, dans la zone du bord de ladite surface de l'objet en forme de disque, pour permettre un traitement par liquide de cette zone de bord, que la partie (3) du système située entre le dispositif d'amenée de gaz et le dispositif de guidage de gaz se trouve par rapport à l'objet en forme de disque à une plus grande distance (b) que le dispositif de guidage de gaz (4) par rapport à l'objet en forme de disque (W) (distance a), et que le dispositif de guidage de gaz ne touche pas l'objet en forme de disque pendant le fonctionnement.

2. Dispositif suivant la revendication 1, dans lequel le dispositif de guidage de gaz (4) présente un diamètre intérieur qui est inférieur au diamètre extérieur de l'objet en forme de disque (W) et un diamètre extérieur qui est au moins égal au diamètre extérieur de l'objet en forme de disque.

3. Dispositif suivant la revendication 1, dans lequel le dispositif de guidage de gaz (4) présente une arête vive à sa périphérie intérieure.

4. Dispositif suivant la revendication 1, dans lequel la fente (10) entre le dispositif de guidage de gaz (4) et l'objet en forme de disque (W) vaut de 0, 05 à 1 mm (distance a).

5. Dispositif suivant la revendication 4, dans lequel la fente (10) entre le dispositif de guidage de gaz (4) et l'objet en forme de disque (W) vaut de 0,1 à 0,5 mm (distance a).

6. Dispositif suivant la revendication 1, dans lequel la surface (14) du dispositif de guidage de gaz (4) tournée vers l'objet en forme de disque (W) est parallèle aux surfaces principales de l'objet en forme de disque.

7. Dispositif suivant la revendication 1, comprenant au moins deux éléments de guidage (25) qui sont disposés perpendiculairement au système et délimitent la position de l'objet en forme de disque côté périphérie.

8. Dispositif suivant la revendication 7, dans lequel le dispositif d'amenée de gaz (5) établit un coussin de gaz qui amène l'objet en forme de disque en état de suspension.

9. Dispositif suivant la revendication 1, dans lequel la partie (2) du système à l'intérieur du dispositif d'amenée de gaz touche l'objet en forme de disque.

10. Dispositif suivant la revendication 9, dans lequel la partie (2) du système à l'intérieur du dispositif d'amenée de gaz peut être mise en dépression.

11. Dispositif suivant la revendication 1, dans lequel le système peut être entraîné en rotation (R).

12. Procédé pour le traitement par liquide d'une zone (d) définie, proche du bord, d'un objet en forme de disque, en particulier d'une plaquette de semi-conducteur (W), comprenant un dispositif suivant la revendication 1, dans lequel le liquide (E) est appliqué sur une première surface, s'écoule essentiellement radialement vers l'extérieur vers le bord périphérique (E) de l'objet en forme de disque (W) et s'écoule autour de ce bord (E) sur la seconde surface, **caractérisé par le fait que** le liquide mouille sur la seconde surface une portion définie proche du bord et est ensuite éloigné de l'objet en forme de disque.

13. Procédé suivant la revendication 12, dans lequel la zone de bord (d) vaut plus de 2 mm.

14. Procédé suivant la revendication 12, dans lequel l'objet en forme de disque tourne autour de son axe (A) pendant le traitement par liquide.

15. Procédé suivant la revendication 14, dans lequel la vitesse de rotation est d'au moins 100/min.
